# EUROPÄISCHE PATENTSCHRIFT

(11) **EP 3 562 284 B1**
(45) Veröffentlichungstag und Bekanntmachung des Hinweises auf die Patenterteilung: **16.11.2022**
(21) Anmeldenummer: 18169240.1
(22) Anmeldetag: 25.04.2018
(51) Int. Cl.: H05K 7/14, H05K 9/00

(54) **VERFAHREN ZUR HERSTELLUNG EINER BACKPLANE UND SCHALTSCHRANK MIT EINER SOLCHEN BACKPLANE**
METHOD OF MANUFACTURING A BACKPLANE AND CONTROL CABINET COMPRISING SUCH A BACKPLANE
PROCÉDÉ DE FABRICATION D'UN FOND DE PANIER ET ARMOIRE DE COMMANDE COMPRENANT UN TEL DE FON DE PANIER

(43) Veröffentlichungstag der Anmeldung: 30.10.2019
(73) Patentinhaber: Siemens Aktiengesellschaft, 80333 München (DE)
(72) Erfinder: Seidl, Joachim, 92237 Sulzbach-Rosenberg (DE)

(56) Entgegenhaltungen:
- EP-A1- 1 553 630
- EP-A1- 1 947 923
- EP-A2- 0 199 309
- EP-A2- 1 311 146
- DE-A1-102014 215 463
- DE-A1-102016 002 052
- US-A- 5 036 160
- US-A1- 2012 247 800
- US-A1- 2014 268 625

## Beschreibung

Die Erfindung betrifft ein Verfahren zur Herstellung einer Backplane zum elektrischen Verbinden elektrischer Bauelemente. Ferner betrifft die Erfindung einen Schaltschrank.

Unter einer Backplane wird hier ein Träger für elektrische Bauelemente verstanden, der elektrische Leitungen zum elektrischen Verbinden der elektrischen Bauelemente aufweist. Derartige elektrische Bauelemente sind beispielsweise Schütze, Schalter, Steuerungseinheiten oder Eingabe-/ Ausgabeeinheiten. In einem Schaltschrank werden elektrische Bauelemente einer technischen Vorrichtung oder Anlage angeordnet. In herkömmlichen Schaltschränken werden elektrische Bauelemente in der Regel durch Kabel elektrisch miteinander verbunden. Bei einer Vielzahl elektrischer Bauelemente entsteht dabei ein hoher Verkabelungsaufwand.

DE 10 2016 002 052 A1 (Liebherr-Components Biberach GmbH) 22. Juni 2017 offenbart einen Schaltschrank und ein Verfahren zu dessen Herstellung. Der Schaltschrank weist zumindest eine Schalttafel mit einer Grundplatte auf, auf der elektrische Schaltelemente angeordnet und miteinander elektrisch verbunden sind. Die zumindest eine Grundplatte und/oder zumindest eines der Schaltelemente wird mittels eines 3D-Druckers in einem 3D-Druckverfahren hergestellt.

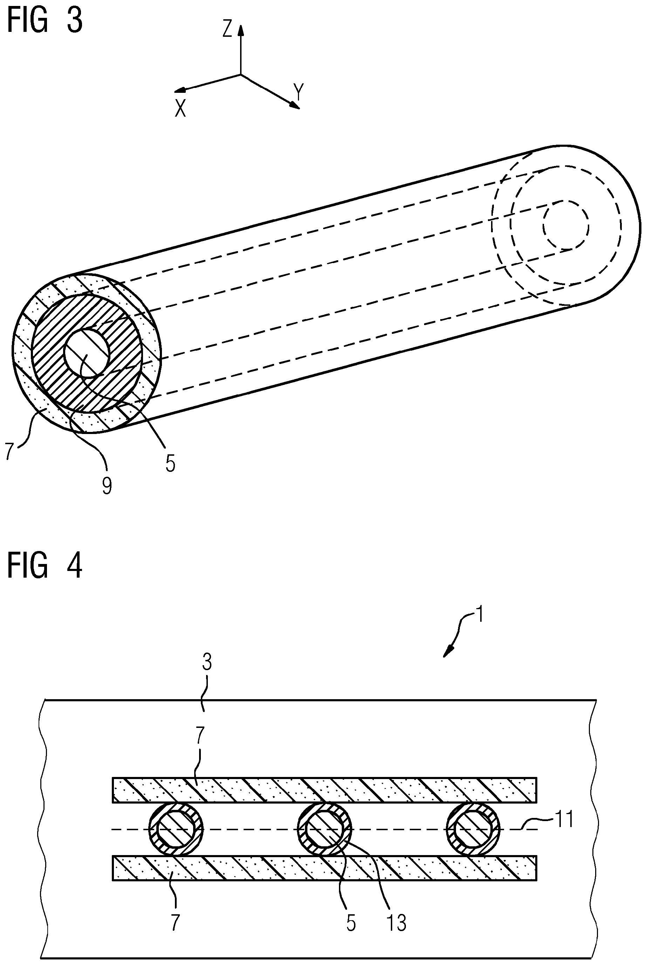

US 5 036 160 A (Jackson, Joseph M.) 30. Juli 1991 beschreibt eine Backplane mit einer Schicht aus Isoliermaterial und einer durchgehenden Leitung, die zwischen Leitungssegmenten auf einer ersten und einer zweiten Oberfläche des Isoliermaterials abwechselt. Fig. 3 zeigt, dass eine Vielzahl von Leitungs- oder Abschirmschichten vorgesehen wird. Es wird also eine Abschirmung von elektrischen Leitungen offenbart, aber kein 3D-Druck.

EP 1 311 146 A2 (ALCATEL) 14. Mai 2003 beschreibt eine elektrische Abschirmung zur Montage auf einer Backplane eines Telekommunikationsgeräte-Racks, die elektromagnetische Störungen (EMI) dämpft und vor elektrostatischer Entladung (ESD) schützt. Es wird also eine Abschirmung von elektrischen Leitungen offenbart, aber kein 3D-Druck.

EP 1 553 630 A1 (Sony Corporation) 13. Juli 2005 beschreibt ein Hochfrequenzmodul, das für ein drahtloses Kommunikationsmodul verwendet wird und ein organisches Substrat 11 umfasst, auf dessen Oberflächen leitfähige Muster gebildet sind. Fig. 8 zeigt eine metallische Abschirmschicht 23 auf dem Substrat 11. Es wird also eine Abschirmung von elektrischen Leitungen offenbart, aber kein 3D-Druck.

Der Erfindung liegt die Aufgabe zugrunde, ein verbessertes Verfahren zur Herstellung einer Backplane und einen verbesserten Schaltschrank anzugeben.

Die Aufgabe wird erfindungsgemäß durch ein Verfahren mit den Merkmalen des Anspruchs 1 und einen Schaltschrank mit den Merkmalen des Anspruchs 11 gelöst.

Vorteilhafte Ausgestaltungen der Erfindung sind Gegenstand der Unteransprüche.

Ein erfindungsgemäßes Verfahren dient zur Herstellung einer Backplane zum elektrischen Verbinden elektrischer Bauelemente. Die Backplane umfasst eine Trägerplatte, elektrische Leitungen, die jeweils auf und/oder in der Trägerplatte angeordnet sind und wenigstens eine in die Trägerplatte integrierte Abschirmung zum Abschirmen elektrischer und/oder magnetischer Felder.

Die Backplane weist somit eine Trägerplatte auf, die neben elektrischen Leitungen auch wenigstens eine in die Trägerplatte integrierte Abschirmung zum Abschirmen elektrischer und/oder magnetischer Felder aufweist. Dadurch können elektrische Leitungen der Backplane und auf der Backplane angeordnete elektrische Bauelemente durch wenigstens eine in die Backplane integrierte Abschirmung elektrisch und/oder magnetisch geschirmt werden. Herkömmliche Schirmungsmaßnahmen sehen dagegen beispielsweise eine zusätzliche Montage von Schirmgeflechtsschläuchen oder die Verwendung von Montageplatten, die der Schirmung und zentralen Erdung dienen, vor. Derartige Schirmungsmaßnahmen erfordern zusätzliche Komponenten und erhöhen den Aufwand im Produktionsprozess, die Materialkosten und den Platzbedarf. Die erfindungsgemäße Integration einer Abschirmung in die Backplane verringert somit vorteilhaft den Aufwand, die Kosten und den Platzbedarf für die Schirmung von elektrischen Leitungen einer Backplane und auf der Backplane angeordneten elektrischen Bauelementen.

Ausgestaltungen der Erfindung sehen vor, dass jede Abschirmung aus einem elektrisch und/oder magnetisch leitfähigen Material gefertigt ist. Beispielsweise ist wenigstens eine Abschirmung aus Graphen gefertigt, und/oder wenigstens eine Abschirmung ist aus Kohlenstoffnanoröhren gefertigt ist, und/oder wenigstens eine Abschirmung ist aus einem mit Kohlenstoffnanoröhren gefüllten Kunststoff gefertigt. Ferner kann wenigstens eine Abschirmung als ein elektrisch und/oder magnetisch leitfähiges Gewebe ausgebildet sein. Diese Ausgestaltungen der Erfindung nutzen insbesondere aus, dass Graphen und Kohlenstoffnanoröhren sehr gute Schirmeigenschaften und zudem sehr gute Wärmeleitfähigkeiten aufweisen und somit neben dem Abschirmen elektrischer und/oder magnetischer Felder auch einer verbesserten Wärmeableitung aus der Backplane dienen können.

Eine weitere Ausgestaltung der Erfindung sieht vor, dass wenigstens eine Abschirmung wenigstens eine elektrische Leitung ummantelt. Dabei kann jede von einer Abschirmung ummantelte elektrische Leitung von einem elektrisch isolierenden Isolationsmaterial, beispielsweise von einem Isolierlack, umhüllt sein. Diese Ausgestaltungen der Erfindung ermöglichen eine Schirmung einer elektrischen Leitung oder mehrerer elektrischer Leitungen der Backplane durch eine Ummantelung mit einer in die Backplane integrierten Abschirmung. Die Umhüllung der abgeschirmten Leitungen durch ein Isolationsmaterial verhindert vorteilhaft einen elektrischen Kontakt der elektrischen Leitungen mit der Abschirmung.

Eine weitere Ausgestaltung der Erfindung sieht vor, dass wenigstens eine Abschirmung parallel zu einer Leitungsebene, in der mehrere elektrische Leitungen angeordnet sind, verläuft. Diese Ausgestaltung der Erfindung berücksichtigt, dass häufig mehrere elektrische Leitungen in derselben Leitungsebene angeordnet sind und daher gemeinsam durch eine zu der Leitungsebene parallele Abschirmung geschirmt werden können.

Ein erfindungsgemäßer Schaltschrank weist eine gemäß einem erfindungsgemäßen Verfahren hergestellte Backplane auf.

Die Verwendung einer erfindungsgemäß hergestellten Backplane in einem Schaltschrank reduziert vorteilhaft den Aufwand und die Kosten zum elektrischen Verbinden elektrischer Bauelemente in dem Schaltschrank gegenüber dem herkömmlichen Verbinden elektrischer Bauelemente durch Kabel. Die Integration von wenigstens einer Abschirmung in die Backplane hat darüber hinaus die oben bereits genannten Vorteile, den Aufwand, die Kosten und den Platzbedarf für die Schirmung von elektrischen Leitungen und Bauelementen des Schaltschranks zu reduzieren.

Bei dem erfindungsgemäßen Verfahren zur Herstellung einer erfindungsgemäßen Backplane wird die wenigstens eine Abschirmung mit einem additiven Fertigungsverfahren in die Trägerplatte integriert. Dabei wird die wenigstens eine Abschirmung in die Trägerplatte integriert, indem die Trägerplatte wenigstens in einem die Abschirmung umgebenden Bereich mit einem 3D-Druck gefertigt wird, der die Abschirmung in die Trägerplatte einbettet. Insbesondere kann die Abschirmung selbst mit einem 3D-Druck gefertigt werden.

Unter einem 3D-Druck wird ein Verfahren verstanden, bei dem ein dreidimensionales Objekt durch computergesteuertes schichtweises Auftragen von Material hergestellt wird.

Die Integration einer Abschirmung in die Trägerplatte mit einem additiven Fertigungsverfahren, nämlich mit einem 3D-Druck der Trägerplatte wenigstens im Bereich der Abschirmung, ermöglicht insbesondere eine flexible Gestaltung unterschiedlichster Geometrien der Abschirmung und damit eine den jeweils gewünschten Schirmungseffekten präzise anpassbare Schirmung von elektrischen Leitungen einer Backplane und auf der Backplane angeordneten elektrischen Bauelementen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine erste Schnittdarstellung eines ersten Ausführungsbeispiels einer Backplane,
- FIG 2: eine zweite Schnittdarstellung des ersten Ausführungsbeispiels einer Backplane,
- FIG 3: eine perspektivische Darstellung einer elektrischen Leitung und einer Abschirmung,
- FIG 4: eine Schnittdarstellung eines zweiten Ausführungsbeispiels einer Backplane,
- FIG 5: eine perspektivische Darstellung eines Schaltschranks.

Einander entsprechende Teile sind in den Figuren mit denselben Bezugszeichen versehen.

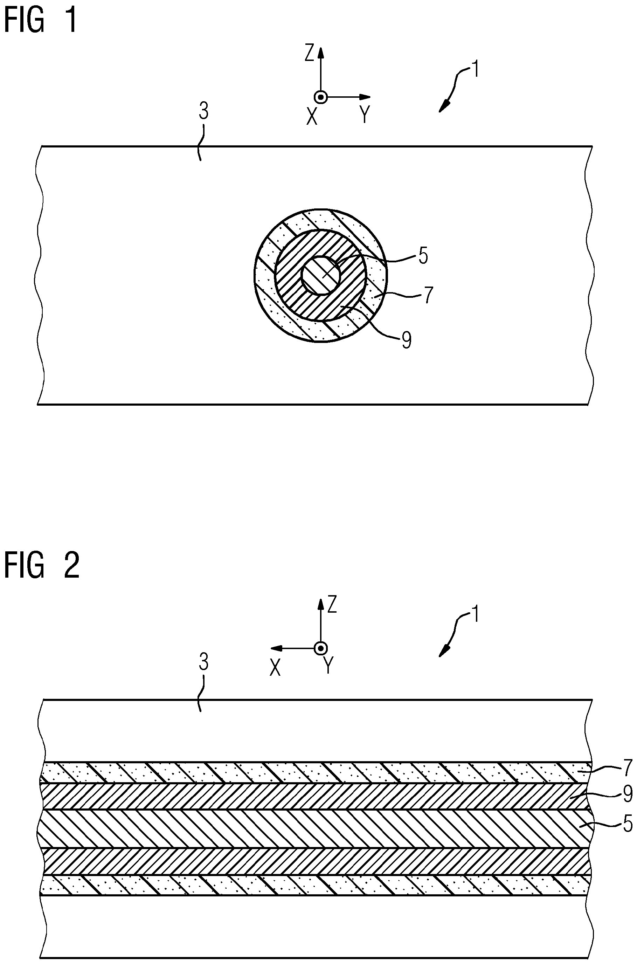

Die Figuren 1 und 2 zeigen schematisch ein erstes Ausführungsbeispiel einer erfindungsgemäß hergestellten Backplane 1 in zwei zueinander senkrechten Schnittebenen. Die Backplane 1 weist eine Trägerplatte 3, eine elektrische Leitung 5 und eine Abschirmung 7 auf.

Die elektrische Leitung 5 ist aus einem elektrisch leitfähigen Material, beispielsweise aus Kupfer, gefertigt.

Die Abschirmung 7 ist röhrenartig ausgebildet und ummantelt die elektrische Leitung 5, wobei ihre Innenoberfläche von der elektrischen Leitung 5 beabstandet ist. Die Abschirmung 7 ist aus einem elektrisch leitfähigen Material gefertigt und schirmt die elektrische Leitung 5 elektrisch ab. Alternativ oder zusätzlich kann die Abschirmung 7 zur magnetischen Abschirmung der elektrischen Leitung 5 ausgebildet sein und dazu eine ausreichende magnetische Permeabilität aufweisen. Beispielsweise ist die Abschirmung 7 aus Graphen oder aus Kohlenstoffnanoröhren oder aus einem mit Kohlenstoffnanoröhren gefüllten Kunststoff gefertigt.

Die elektrische Leitung 5 ist von einem elektrisch isolierenden Isolationsmaterial 9 umhüllt, das einen Zwischenraum zwischen der elektrischen Leitung 5 und der Abschirmung 7 ausfüllt. Das Isolationsmaterial 9 ist beispielsweise ein Isolierlack oder ein Kunststoff und isoliert die elektrische Leitung 5 von der Abschirmung 7.

Die elektrische Leitung 5, die Abschirmung 7 und das Isolationsmaterial 9 sind in der Trägerplatte 3 angeordnet.

Figur 3 zeigt eine perspektivische Darstellung der in den Figuren 1 und 2 gezeigten elektrischen Leitung 5 und Abschirmung 7.

Figur 4 zeigt eine Schnittdarstellung eines zweiten Ausführungsbeispiels einer Backplane 1. Die Backplane 1 weist eine Trägerplatte 3, mehrere elektrische Leitungen 5 und zwei Abschirmungen 7 auf.

Die elektrischen Leitungen 5 sind in einer Leitungsebene 11 angeordnet und aus einem elektrisch leitfähigen Material, beispielsweise aus Kupfer, gefertigt.

Die Abschirmungen 7 sind jeweils plattenartig ausgebildet und verlaufen auf unterschiedlichen Seiten der Leitungsebene 11 parallel zu der Leitungsebene 11. Die Abschirmungen 7 sind aus einem elektrisch leitfähigen Material gefertigt und schirmen die elektrischen Leitungen 5 elektrisch ab. Alternativ oder zusätzlich können die Abschirmungen 7 zur magnetischen Abschirmung der elektrischen Leitungen 5 ausgebildet sein und dazu eine ausreichende magnetische Permeabilität aufweisen. Beispielsweise sind die Abschirmungen 7 aus Graphen oder aus Kohlenstoffnanoröhren oder aus einem mit Kohlenstoffnanoröhren gefüllten Kunststoff gefertigt.

Die elektrischen Leitungen 5 verlaufen zwischen den beiden Abschirmungen 7. Jede elektrische Leitung 5 ist mit einer Isolationsschicht 13 beschichtet, die die elektrische Leitung 5 von den Abschirmungen 7 elektrisch isoliert. Die Isolationsschichten 13 sind aus einem elektrisch isolierenden Isolationsmaterial 9, beispielsweise aus einem Isolierlack oder einem Kunststoff, gefertigt.

Bei den anhand der Figuren 1 bis 4 beschriebenen Ausführungsbeispielen werden die Abschirmungen 7 jeweils mit dem additiven Fertigungsverfahren des 3D-Drucks in die Trägerplatte 3 integriert. Dabei wird die Trägerplatte 3 wenigstens in einem eine Abschirmung 7 umgebenden Bereich mit einem 3D-Druck gefertigt, der die Abschirmung 7 in die Trägerplatte 3 einbettet. Ferner können auch die elektrischen Leitungen 5 und die Abschirmungen 7 mit einem 3D-Druck gefertigt werden.

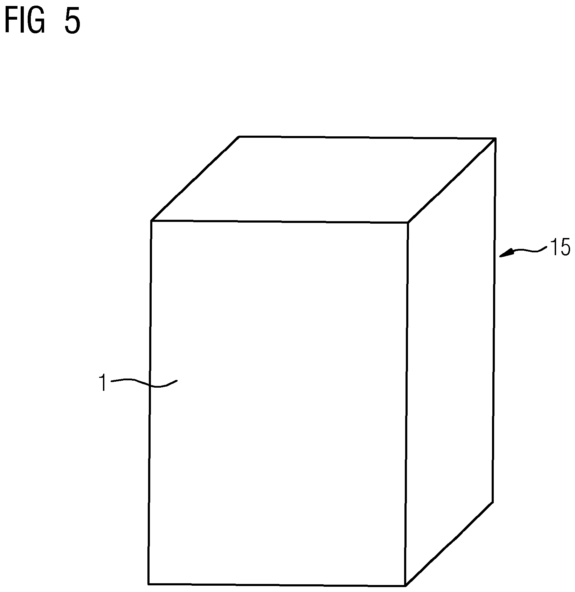

Figur 5 zeigt eine perspektivische Darstellung eines Schaltschranks 15. Der Schaltschrank 15 weist eine wie in einem der oben beschriebenen Ausführungsbeispiele ausgebildete Backplane 1 auf, die eine Rückwand des Schaltschranks 15 bildet. Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen wie er durch die angehängten Ansprüche definiert ist.

## Patentansprüche

1. Verfahren zur Herstellung einer Backplane (1) zum elektrischen Verbinden elektrischer Bauelemente, die Backplane (1) umfassend
- eine Trägerplatte (3),
- elektrische Leitungen (5), die jeweils auf und/oder in der Trägerplatte (3) angeordnet sind, und
- wenigstens eine in die Trägerplatte (3) integrierte Abschirmung (7) zum Abschirmen elektrischer und/oder magnetischer Felder,
**dadurch gekennzeichnet,**
**dass** die wenigstens eine Abschirmung (7) in die Trägerplatte (3) integriert wird, indem die Trägerplatte (3) wenigstens in einem die Abschirmung (7) umgebenden Bereich mit einem 3D-Druck gefertigt wird, der die Abschirmung (7) in die Trägerplatte (3) einbettet.

2. Verfahren nach Anspruch 1,
**dadurch gekennzeichnet, dass** jede Abschirmung (7) aus einem elektrisch und/oder magnetisch leitfähigen Material gefertigt ist.

3. Verfahren nach Anspruch 2,
**dadurch gekennzeichnet, dass** wenigstens eine Abschirmung (7) aus Graphen gefertigt ist.

4. Verfahren nach Anspruch 2 oder 3,
**dadurch gekennzeichnet, dass** wenigstens eine Abschirmung (7) aus Kohlenstoffnanoröhren gefertigt ist.

5. Verfahren nach einem der Ansprüche 2 bis 4,
**dadurch gekennzeichnet, dass** wenigstens eine Abschirmung (7) aus einem mit Kohlenstoffnanoröhren gefüllten Kunststoff gefertigt ist.

6. Verfahren nach einem der vorhergehenden Ansprüche, **dadurch gekennzeichnet, dass** wenigstens eine Abschirmung (7) als ein elektrisch und/oder magnetisch leitfähiges Gewebe ausgebildet ist.

7. Verfahren nach einem der vorhergehenden Ansprüche, **dadurch gekennzeichnet, dass** wenigstens eine Abschirmung (7) wenigstens eine elektrische Leitung (5) ummantelt.

8. Verfahren nach Anspruch 7,
**dadurch gekennzeichnet, dass** jede von einer Abschirmung (7) ummantelte elektrische Leitung (5) von einem elektrisch isolierenden Isolationsmaterial (9) umhüllt ist.

9. Verfahren nach Anspruch 8,
**dadurch gekennzeichnet, dass** das Isolationsmaterial (9) ein Isolierlack ist.

10. Verfahren nach einem der vorhergehenden Ansprüche, **dadurch gekennzeichnet, dass** wenigstens eine Abschirmung (7) parallel zu einer Leitungsebene (11), in der mehrere elektrische Leitungen (5) angeordnet sind, verläuft.

11. Schaltschrank (15) mit einer gemäß einem der vorhergehenden Ansprüche hergestellten Backplane (1).

## Claims

1. Method of manufacturing a backplane (1) for the electrical connection of electrical components, the backplane (1) comprising
- a support plate (3),
- electrical lines (5), which are each arranged on and/or in the support plate (3), and
- at least one shield (7) integrated into the support plate (3) to shield against electrical and/or magnetic fields,
**characterized in that**
the at least one shield (7) is integrated into the support plate (3) **in that**, at least in a region surrounding the shield (7), the support plate (3) is made with a 3D print, which embeds the shield (7) in the support plate (3).

2. Method according to Claim 1,
**characterized in that** each shield (7) is made of an electrically and/or magnetically conductive material.

3. Method according to Claim 2,
**characterized in that** at least one shield (7) is made of graphene.

4. Method according to Claim 2 or 3,
**characterized in that** at least one shield (7) is made of carbon nanotubes.

5. Method according to one of Claims 2 to 4,
**characterized in that** at least one shield (7) is made of a plastic filled with carbon nanotubes.

6. Method according to one of the preceding claims, **characterized in that** at least one shield (7) is formed as an electrically and/or magnetically conductive fabric.

7. Method according to one of the preceding claims, **characterized in that** at least one shield (7) encases at least one electrical line (5).

8. Method according to Claim 7,
**characterized in that** each electrical line (5) that is encased by a shield (7) is sheathed by an electrically insulating insulation material (9).

9. Method according to Claim 8,
**characterized in that** the insulation material (9) is an insulating varnish.

10. Method according to one of the preceding claims, **characterized in that** at least one shield (7) runs parallel to a line plane (11) in which a plurality of electrical lines (5) are arranged.

11. Control cabinet (15) having a backplane (1) manufactured according to one of the preceding claims.

## Revendications

1. Procédé de fabrication d'un fond de panier (1) pour la connexion électrique de composants électriques, le fond de panier (1) comprenant
- une plaque (3) support,
- des lignes (5) électriques, qui sont disposées chacune sur et/ou dans la plaque (3) support, et
- au moins un blindage (7) intégré à la plaque (3) support pour le blindage vis-à-vis de champs électriques et/ou magnétiques,
**caractérisé**
**en ce que** l'on intègre le au moins un blindage (7) dans la plaque (3) support, par le fait que l'on fabrique la plaque (3) support au moins dans une partie entourant le blindage (7) par une impression en 3D, qui noie le blindage (7) dans la plaque (3) support.

2. Procédé suivant la revendication 1,
**caractérisé en ce que** chaque blindage (7) est en un matériau conducteur électriquement et/ou magnétiquement.

3. Procédé suivant la revendication 2,
**caractérisé en ce qu'**au moins un blindage (7) est en graphène.

4. Procédé suivant la revendication 2 ou 3,
**caractérisé en ce qu'**au moins un blindage (7) est en nanotubes de carbone.

5. Procédé suivant l'une des revendications 2 à 4, **caractérisé en ce qu'**au moins un blindage (7) est en une matière plastique chargée de nanotubes de carbone.

6. Procédé suivant l'une des revendications précédentes, **caractérisé en ce qu'**au moins un blindage (7) est constitué sous la forme d'un tissu conducteur électriquement et/ou magnétiquement.

7. Procédé suivant l'une des revendications précédentes, **caractérisé en ce qu'**au moins un blindage (7) gaine au moins une ligne (5) électrique.

8. Procédé suivant la revendication 7,
**caractérisé en ce que** chaque ligne (5) électrique gainée d'un blindage (7) est enrobée d'un matériau (9) isolant électriquement.

9. Procédé suivant la revendication 8,
**caractérisé en ce que** le matériau (9) isolant est un vernis isolant.

10. Procédé suivant l'une des revendications précédentes, **caractérisé en ce qu'**au moins un blindage (7) s'étend parallèlement à un plan (11) de ligne, dans lequel passent plusieurs lignes (5) électriques.

11. Armoire (15) de commande ayant un fond de panier (1) fabriqué suivant l'une des revendications précédentes.
